# EUROPEAN PATENT APPLICATION

(11) **EP 2 461 373 A1**
(43) Date of publication of application: **06.06.2012**
(21) Application number: 10804521.2
(22) Date of filing: 29.07.2010
(51) Int. Cl.: H01L 31/075, H01L 31/0224, H01B 5/14, C23C 16/40

(54) **TRANSPARENT CONDUCTIVE SUBSTRATE FOR SOLAR CELLS, AND SOLAR CELL**

(30) Priority: 30.07.2009 JP 2009177702; 06.07.2010 JP 2010154101
(71) Applicant: Asahi Glass Company, Limited, Chiyoda-ku Tokyo 100-8405 (JP)
(72) Inventor: MATSUI, Yuji, Tokyo 100-8405 (JP); MINAMI, Kenichi, Tokyo 100-8405 (JP)
(74) Representative: Müller-Boré & Partner Patentanwälte
(86) International application number: PCT/JP2010/062850
(87) International publication number: WO 2011/013775

(57) **Abstract**

To provide a transparent conductive substrate for a solar cell, which has a haze factor at the same level of conventional transparent conductive substrates for a solar cell, and a small amount of absorbed light at a wavelength region of about 400 nm by a tin oxide layer.

A transparent conductive substrate for a solar cell, comprising a substrate and at least a silicon oxide layer and a tin oxide layer formed thereon in this order, wherein on the silicon oxide layer between the silicon oxide layer and the tin oxide layer, discontinuous ridge parts consisting of tin oxide and a crystalline thin layer consisting of an oxide containing substantially no tin oxide are formed.

## Description

### TECHNICAL FIELD

The present invention relates to a transparent conductive substrate for a solar cell, and a solar cell.

### BACKGROUND ART

Solar cells are desired to have their photoelectric conversion efficiency increased in order to utilize the incident sunlight energy to the maximum extent.

As a means to increase the photoelectric conversion efficiency, it is known to increase the electric current flowing through a transparent conductive substrate for a solar cell to be used as an electrode for solar cells. For such a purpose, it is known to increase the haze factor, and a method of forming irregularities on the surface of a conductive film (tin oxide layer) is, for example, known (e.g. Patent Documents 1 and 2).

Further, the transparent conductive substrate for a solar cell, which is used as an electrode for a solar cell usually has a structure such that a transparent conductive oxide film is formed on a substrate which is excellent in transparency such as glass.

For such a transparent conductive substrate for a solar cell, heretofore, a laminated film having a silicon oxide layer and a tin oxide layer formed in this order from the substrate side or a laminated film having a titanium oxide layer, a silicon oxide layer and a tin oxide layer formed in this order from the substrate side has been preferably used.

For example, in Patent Document 3, the present applicant has proposed "a transparent conductive substrate for a solar cell, comprising a substrate and a TiO₂ layer, an SiO₂ layer and an SnO₂ layer formed thereon in this order, wherein the film thickness of the SnO₂ layer is from 0.5 to 0.9 µm, and the haze factor for illuminant C is from 20 to 60%".

Further, in Patent Document 4, the present applicant has proposed "a transparent conductive substrate for a solar cell, comprising a substrate and at least two layers including a silicon oxide layer and a multilaminated tin oxide layer adjacent to the silicon oxide layer, formed in this order from the substrate side, wherein the multilaminated tin oxide layer has at least one tin oxide layer doped with fluorine and at least one tin oxide layer not doped with fluorine".

### PRIOR ART DOCUMENTS

### PATENT DOCUMENTS

Patent Document 1: JP-A-2002-260448
Patent Document 2: JP-A-2001-36117
Patent Document 3: WO2004/102677
Patent Document 4: WO2007/058118

### DISCLOSURE OF INVENTION

### TECHNICAL PROBLEM

However, as a result of a study by the present inventors, it has been found that in a case where a tin oxide layer is formed on a silicon oxide layer, a tin oxide layer having a low crystallinity is formed in the vicinity of an interface of such layers (on the tin oxide layer side), and the tin oxide layer having a low crystallinity absorbs light in a wavelength region of about 400 nm.

Accordingly, it is an object of the present invention to provide a transparent conductive substrate for a solar cell, which has a high haze factor at a level of conventional transparent conductive substrates for a solar cell, whereby in the tin oxide layer, the absorption of light in a wavelength region of about 400 nm is low.

### SOLUTION TO PROBLEM

As a result of an extensive research to accomplish the above object, the present inventors have found that in a transparent conductive substrate for a solar cell, comprising a substrate and at least a silicon oxide layer and a tin oxide layer formed thereon in this order from the substrate side, by forming on the silicon oxide layer between the silicon oxide layer and the tin oxide layer, discontinuous ridge parts consisting of tin oxide and a crystalline thin layer consisting of an oxide containing substantially no tin oxide, it is possible to reduce the absorption of light in a wavelength region of about 400 nm in the tin oxide layer, while maintaining a high haze factor. Thus, the present invention has been accomplished.

That is, the present invention provides the following (1) to (12).
(1) A transparent conductive substrate for a solar cell, comprising a substrate and at least a silicon oxide layer and a tin oxide layer formed thereon in this order, wherein on the silicon oxide layer between the silicon oxide layer and the tin oxide layer, discontinuous ridge parts consisting of tin oxide and a crystalline thin layer consisting of an oxide containing substantially no tin oxide are formed.
(2) The transparent conductive substrate for a solar cell according to the above (1), wherein the ridge parts and the crystalline thin layer are formed so as to contact the tin oxide layer.
(3) The transparent conductive substrate for a solar cell according to the above (1), wherein the ridge parts are covered with the crystalline thin layer.
(4) The transparent conductive substrate for a solar cell according to any one of the above (1) to (3), wherein the ridge parts have an average bottom surface diameter of from 20 to 1,000 nm, an average density of from 1 to 100 ridges/µm² and an average covering proportion of from 3 to 90% on the surface of the silicon oxide layer.
(5) The transparent conductive substrate for a solar cell according to any one of the above (1) to (4), wherein the ridge parts have an average height of from 10 to 200 nm, an average bottom surface diameter of from 20 to 1,000 nm, an average density of from 1 to 100 ridges/µm² and an average covering proportion of from 3 to 90% on the surface of the silicon oxide layer.
(6) The transparent conductive substrate for a solar cell according to any one of the above (1) to (5), wherein the ridges parts are formed by atmospheric pressure CVD method using tin tetrachloride and water wherein the amount of water is at most 60 times by molar ratio to the tin tetrachloride (H₂O/SnCl₄).
(7) The transparent conductive substrate for a solar cell according to any one of the above (1) to (6), wherein the haze factor for illuminant C is from 5 to 40%.
(8) The transparent conductive substrate for a solar cell according to the above (7), wherein the ridges parts are formed by atmospheric pressure CVD method using tin tetrachloride and water wherein the amount of water is at most 30 times by molar ratio to the tin tetrachloride (H₂O/SnCl₄).
(9) The transparent conductive substrate for a solar cell according to any one of the above (1) to (8), wherein the crystalline thin layer is a titanium oxide layer.
(10) The transparent conductive substrate for a solar cell according to any one of the above (1) to (8), which further has a titanium oxide layer between the substrate and the silicon oxide layer.
(11) A solar cell, which has the transparent conductive substrate for a solar cell as defined in any one of the above (1) to (10).
(12) A process for producing the transparent conductive substrate for a solar cell, which comprises forming by atmospheric pressure CVD method, at least a silicon oxide layer, discontinuous ridge parts consisting of tin oxide, a crystalline thin film consisting of an oxide containing substantially no tin oxide and a tin oxide layer in this order on a substrate, wherein the ridges parts are formed by atmospheric pressure CVD method using tin tetrachloride and water wherein the amount of water is at most 60 times by molar ratio to the tin tetrachloride (H₂O/SnCl₄).

### ADVANTAGEOUS EFFECTS OF INVENTION

As explained after, according to the present invention, it is possible to provide a transparent conductive substrate for a solar cell, which has a high haze factor at a level of conventional transparent conductive substrates for a solar cell, wherein in the tin oxide layer, the absorption of light in a wavelength region of about 400 nm is low.

### BRIEF DESCRIPTION OF DRAWINGS

Fig. 1 is a schematic cross-sectional view illustrating one embodiment of the transparent conductive substrate for a solar cell of the present invention.
Fig. 2 is a schematic cross-sectional view illustrating another embodiment of the transparent conductive substrate for a solar cell of the present invention.
Fig. 3 is a schematic cross-sectional view illustrating one embodiment of a solar cell of a tandem structure employing the transparent conductive substrate for a solar cell of the present invention.
Fig. 4 is an electron microscopic photograph showing the film surface after having discontinuous ridge parts consisting of tin oxide formed in Example 1.
Fig. 5 is an electron microscopic photograph showing the surface of the transparent conductive substrate for a solar cell produced in Example 1.
Fig. 6 is an electron microscopic photograph showing the surface of the transparent conductive substrate for a solar cell produced in Comparative Example 1.
Fig. 7 is an electron microscopic photograph showing the surface of the transparent conductive substrate for a solar cell produced in Comparative Example 2.
Figs. 8 are electron microscopic photographs showing the surfaces of the transparent conductive substrates for solar cells produced in Examples 2 to 4.
Figs. 9 are electron microscopic photographs showing the surfaces of the transparent conductive substrates for solar cells produced in Comparative Examples 3 to 5.
Fig. 10 is a graph showing the relationship between the average height of the discontinuous ridge parts and the haze factor (adjustment of the haze factor) of the transparent conductive substrates for solar cells produced in Examples 2 to 4 and Comparative Examples 3 to 5.

### DESCRIPTION OF EMBODIMENTS

Now, the present invention will be described in detail.

The transparent conductive substrate for a solar cell of the present invention is a transparent conductive substrate for a solar cell, comprising a substrate and at least a silicon oxide layer and a tin oxide layer formed thereon in this order, wherein on the silicon oxide layer between the silicon oxide layer and the tin oxide layer, discontinuous ridge parts (hereinafter simply referred to as "ridge parts") consisting of tin oxide and a crystalline thin layer consisting of an oxide containing substantially no tin oxide (hereinafter simply referred to as "crystalline thin layer") are formed.

Further, in the transparent conductive substrate for a solar cell of the present invention, the ridge parts and the crystalline thin layer are preferably formed so as to be in contact with the silicon oxide layer, whereby a substrate having a high haze factor can be easily produced, and defects of the tin oxide layer (for example, a grooved structure wherein a grain boundary of tin oxide deeply cuts into in the film thickness direction or a perforated structure wherein crystal particles of tin oxide are not in contact with one another, and holes are formed) can be reduced.

Further, the transparent conductive substrate for a solar cell of the present invention preferably has the ridge parts and the crystalline thin layer in this order from the substrate side between the silicon oxide layer and the tin oxide layer, namely, the ridge parts are preferably covered with the crystalline thin layer, whereby in the tin oxide layer, the absorption of light in a wavelength region of about 400 nm can be reduced.

Now, the structure of the transparent conductive substrate for a solar cell of the present invention will be described with reference to the accompanying drawings.

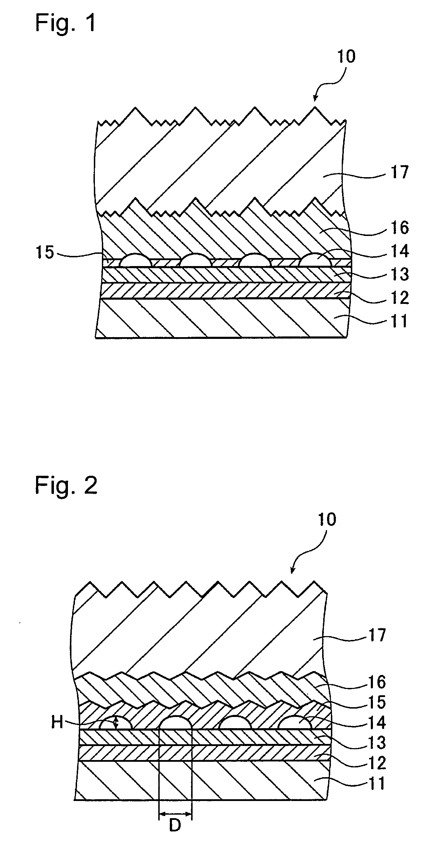

Figs. 1 and 2 are schematic cross-sectional views each illustrating an embodiment of the transparent conductive substrate for a solar cell of the present invention. In each of Figs. 1 and 2, the incident light side of the transparent conductive substrate for a solar cell is located on the down side of the drawing.

The transparent conductive substrate 10 for a solar cell shown in Fig. 1 has, on a substrate 11, a titanium oxide layer 12, a silicon oxide layer 13, ridge parts 14, a crystalline thin layer 15, a first tin oxide layer 16 and a second tin oxide layer 17 in this order from the substrate 11 side. That is, the transparent conductive substrate 10 for a solar cell shown in Fig. 1 is an embodiment wherein the ridge parts 14 and the crystalline thin layer 15 are in contact with the first tin oxide layer 16 (which may hereinafter, be referred to as "first embodiment of the present invention").

On the other hand, the transparent conductive substrate 10 for a solar cell shown in Fig. 2 has, on a substrate 11, a titanium oxide layer 12, a silicon oxide layer 13, ridge parts 14, a crystalline thin layer 15, a first tin oxide layer 16 and a second tin oxide layer 17 in this order from the substrate 11 side. That is, the transparent conductive substrate 10 for a solar cell shown in Fig. 2 is an embodiment wherein the ridge parts 14 are covered with the crystalline thin layer 15 (which may hereinafter, be referred to as "second embodiment of the present invention").

Further, as mentioned hereinafter, in the transparent conductive substrate for a solar cell of the present invention, it is one of preferred embodiments that a titanium oxide layer 12 is provided, and as the tin oxide layer, two layers of a first tin oxide layer 16 and a second tin oxide layer 17 are formed.

### <SUBSTRATE>

The material for the substrate 11 is not particularly limited, but glass or a plastic may, for example, be preferably mentioned from the viewpoint of being excellent in the light transmitting property (the light transmittance) and the mechanical strength. Among them, glass is particularly preferred from the viewpoint of being excellent in the light transmittance, the mechanical strength and the heat resistance and excellent also from the aspect of costs.

The glass is not particularly limited, and it may, for example, be soda lime silicate glass, aluminosilicate glass, lithium aluminosilicate glass, quartz glass, borosilicate glass or alkali-free glass. Among them, soda lime silicate glass is particularly preferred from the viewpoint of being colorless transparent, inexpensive and readily available in the market by specifying the specification for e.g. the area, shape, thickness, etc.

In a case where the substrate 11 is made of glass, the thickness is preferably from 0.2 to 6.0 mm. Within this range, the balance between the mechanical strength and the light transmitting property will be excellent.

The substrate 11 is preferably one excellent in the light transmittance within a wavelength region of from 400 to 1,200 nm. Specifically, it is preferred that the average light transmittance within a wavelength region of from 400 to 1,200 nm exceeds 80%, and it is more preferably at least 85%.

Further, the substrate 11 is preferably one excellent in the insulating properties and preferably one excellent also in the chemical durability and the physical durability.

The substrates 11 shown in Figs. 1 and 2 are flat plates with a flat cross-sectional shape. However, in the present invention, the cross-sectional shape of the substrate is not particularly limited, and it may be suitably selected depending upon the shape of the solar cell to be produced by employing the substrate 11. Namely, the cross-sectional shape may be a curved shape or any other irregular shape.

### <TITANIUM OXIDE LAYER>

In Figs. 1 and 2, the titanium oxide layer 12 is formed on the substrate 11.

In the present invention, when the substrate 11 is made of glass, an embodiment having a titanium oxide layer 12 between the substrate 11 and the after mentioned silicon oxide layer 13 is one of preferred embodiments, since it is possible to suppress reflection at the interface between the substrate 11 and the after mentioned tin oxide layer (in Figs. 1 and 2, the first tin oxide layer 16 and the second tin oxide layer 17, the same will apply in this paragraph) which takes place due to the difference in the refractive index between the substrate and the tin oxide layer.

The titanium oxide layer 12 is a layer made of TiO₂ having a higher refractive index than the substrate 11 to a light within a wavelength region of from 400 to 1,200 nm. The titanium oxide layer 12 is a layer composed substantially of TiO₂, and the proportion of TiO₂ among components contained in the layer is preferably at least 90 mol%, more preferably at least 95 mol%, further preferably at least 98 mol%.

The titanium oxide layer 12 preferably has a thickness of at least 5 nm and less than 22 nm, more preferably from 10 to 20 nm. Within such a range, the fluctuation in the haze factor for illuminant C is small when the transparent conductive substrate 10 for a solar cell is viewed as a whole, and by the anti-reflection effects, the light transmittance, particularly the light transmittance within a wavelength region of from 400 to 1,200 nm, can be made higher.

The titanium oxide layer 12 preferably has an arithmetic average surface roughness (Rₐ) of at most 3 nm, more preferably at most 1 nm, as measured by an atomic force microscope (AFM), before the silicon oxide layer 13 is formed thereon.

Further, in the embodiment 1 and the embodiment 2, instead of the titanium oxide layer 12, a tin oxide layer may be formed.

### <SILICON OXIDE LAYER>

On the titanium oxide layer 12, a silicon oxide layer 13 is formed.

The silicon oxide layer 13 is a layer made of SiO₂ having a lower refractive index than the substrate 11, the first tin oxide layer 16 and the second tin oxide layer 17 to a light within a wavelength region of from 400 to 1,200 nm. The silicon oxide layer 13 is a layer composed substantially of SiO₂, and the proportion of SiO₂ among the components contained in the layer is preferably at least 90 mol%, more preferably at least 95 mol%, further preferably at least 98 mol%.

The silicon oxide layer 13 preferably has a thickness of from 10 to 50 nm, more preferably from 20 to 40 nm, further preferably from 20 to 35 nm. Within such a range, the haze factor for illuminant C of the transparent conductive substrate for a solar cell will be high, and the fluctuation in the haze factor for illuminant C is small when the transparent conductive substrate 10 for a solar cell is viewed as a whole.

The silicon oxide layer 13 preferably has an arithmetic average surface roughness (Rₐ) of at most 3 nm, more preferably at most 1 nm, as measured by an atomic force microscope (AFM), before the ridge parts 14 are formed thereon.

Further, in a case where the substrate is made of glass, the silicon oxide layer 13 suppresses the diffusion of alkali metal ions from the substrate. Further, in a case where the material for the substrate 11 is a glass containing alkali metal ions such as soda lime silicate glass or low alkali-containing glass, the silicon oxide layer 13 will function also as an alkali barrier layer to minimize the diffusion of alkali metal ions from the substrate 11 to the tin ridge parts 14.

Further, the silicon oxide layer 13 functions as a reflection-preventive layer in combination with the titanium oxide layer 12. If the transparent conductive substrate 10 for a solar cell is not provided with a titanium oxide layer 12 and a silicon oxide layer 13, a reflection loss of incident light results due to the difference of light refractive indexes in a wavelength region of from 400 to 1,200 nm between the substrate 11 and the ridge parts 14. However, the transparent conductive substrate 10 for a solar cell has the titanium oxide layer 12 having a higher refractive index to a light within a wavelength region of from 400 to 1,200 nm than the substrate 11, and the silicon oxide layer 13 having a lower refractive index to light within a wavelength region of from 400 to 1,200 nm than the ridge parts 14, between the substrate 11 and the ridge parts 14, whereby the reflection loss of incident light will be reduced, and the light transmittance, particularly the light transmittance within a wavelength region of from 400 to 1,200 nm, will be high.

### <DISCONTINUOUS RIDGE PARTS CONSISTING OF TIN OXIDE>

On the silicon oxide layer 13, discontinuous ridge parts 14 consisting of tin oxide are formed.

The ridge parts 14 are island structure parts consisting of tin oxide and parts where the haze factor for illuminant C of the transparent conductive substrate for a solar cell is increased (scattering of light is increased). The ridge parts 14 are parts substantially consisting of SnO₂, and in components containing in the ridge parts, the proportion of SnO₂ is preferably at least 90 mol%, more preferably at least 95 mol%, further preferably at least 98 mol%.

The discontinuous ridge parts are preferably made of a material such that ridge parts can be easily formed, particularly preferably a material such that ridge parts can be easily formed on the surface of the silicon oxide layer. As a material such that discontinuous ridge parts can be easily formed, tin oxide may be mentioned.

The ridge parts 14 preferably has an average height H of from 10 to 200 nm, more preferably from 20 to 200 nm, further preferably from 30 to 150 nm. Further, in the present invention, the average height of the ridge parts is a value calculated from the concentration of charged tin oxide used for forming ridge parts, and specifically it is a film thickness of a tin oxide film, when a uniform tin oxide film is formed on an area of 1 µm² at such a charged concentration.

Further, the ridge parts 14 preferably have an average bottom diameter D of from 20 to 1,000 nm, more preferably from 40 to 700 nm, further preferably from 100 to 500 nm.

Further, the ridge parts 14 preferably have an average density of from 1 to 100 ridges/µm², more preferably from 1 to 50 ridges/µm², further preferably from 1 to 20 ridges/µm².

Further, the ridge parts 14 preferably have an average covering proportion of the bottom surface on the surface of the silicon oxide layer 13 of from 3 to 90%, more preferably from 10 to 70%, further preferably from 20 to 60%.

When the average height, etc. of the ridge parts 14 are within the above range, the haze factor for illuminant C of the transparent conductive substrate for a solar cell will be sufficiently high, and the fraction of the haze factor for illuminant C as observed as the entire transparent conductive substrate 10 for a solar cell will be low.

Since the ridge parts 14 having an average height within the above range can be easily formed, the ridge parts 14 are preferably formed by atmospheric pressure CVD method using tin tetrachloride and water wherein the amount of water is at most 60 times by molar ratio to the tin tetrachloride (H₂O/SnCl₄).

Particularly, since the haze factor for illuminant C of the transparent conductive substrate for a solar cell can be easily controlled within the range of from 5 to 40%, the above molar ratio is preferably at most 30 times, more preferably from 2 to 30 times, particularly preferably from 5 to 20 times.

### <CRYSTALLINE THIN LAYER CONSISTING OF OXIDE CONTAINING SUBSTANTIALLY NO TIN OXIDE>

In Fig. 1 (first embodiment), on the surface of the silicon oxide layer on which ridge parts 14 are not formed, a crystalline thin layer 15 consisting of an oxide containing substantially no tin oxide is formed.

On the other hand, in Fig. 2 (second embodiment), on the surface of the ridge parts 14 and on the surface of the silicon oxide layer 13 on which ridge parts 14 are not formed, a crystalline thin layer 15 consisting of an oxide containing substantially no tin oxide is formed.

Here, the oxide containing substantially no tin oxide is not particularly restricted, so far as a crystalline thin layer is formed. For example, an oxide of at least one metal selected from the group consisting of Al, Zr and Ti may be preferably mentioned. Particularly, since the ridge parts 14 and the parts where the ridge parts 14 are not formed can be uniformly covered with a crystalline thin layer having a thinner film thickness, an oxide of Ti (titanium oxide layer) is preferred.

The present inventors have found the influence of the crystallite of the crystalline thin layer 15 consisting of an oxide containing substantially no tin oxide and the after-mentioned tin oxide layer (first tin oxide layer 16). Particularly, in a case where a titanium oxide layer is formed as a crystalline thin layer, the size of crystallites of the tin oxide layer which grow thereon is smaller than the size of crystallites of the tin oxide layer which grow on a non-crystalline silicon oxide layer, and the density of crystallites of the tin oxide layer which grow thereon is high, whereby small regular ridges and dents can be formed on the surface of the after-mentioned tin oxide layer.

By providing such a crystalline thin layer 15 in combination with the discontinuous ridge parts consisting of tin oxide, as compared with conventional transparent conductive substrates for a solar cell wherein a tin oxide layer as a conductive layer is formed on a silicon oxide layer, the formation of a tin oxide layer having a low crystallinity in the vicinity of an interface (on the silicon oxide layer side) of these layers can be prevented, whereby the absorption of light in a wavelength region of about 400 nm in the tin oxide layer can be suppressed.

It is considered that as compared with a case where a crystalline thin oxide layer is directly formed on a non-crystalline tin oxide layer, in a case where a crystalline tin oxide layer is formed on a crystalline thin layer (in the first embodiment, a crystalline thin layer and ridge parts), a tin oxide layer having a high crystallinity can be formed from the initial stage of the formation. Further, as compared with a conventional transparent conductive substrate for a solar cell, wherein a tin oxide layer as a conductive layer is formed on a silicon oxide layer, in a case where only a crystalline thin layer consisting of an oxide containing substantially no tin oxide is formed without forming the discontinuous ridge parts consisting of an oxide, although the absorption of light in a wavelength region of about 400 nm can be suppressed, the haze factor for illuminant C is reduced. That is, the discontinuous ridge parts consisting of tin oxide is required for optimizing the haze factor for illuminant C.

Particularly, as described in the first embodiment, by forming the discontinuous ridge pats consisting of tin oxide and the crystalline thin layer so as to be in contact with the after-mentioned tin oxide layer, a substrate having a high haze factor can be easily produced, and defects of the after-mentioned tin oxide layer can be reduced. Since the size of crystal particles of the tin oxide layer formed on the discontinuous ridge parts is different from the size of crystal particles of the tin oxide layer formed on the crystalline thin layer, as shown in Fig. 1, a tin oxide layer reflecting the shape and the density of the discontinuous ridge parts consisting of tin oxide can be formed, and a tin oxide layer having a high density and a small particle size can be formed on the crystalline thin layer.

Further, as described in the second embodiment, even in a case where the discontinuous ridge parts consisting of tin oxide are covered with the crystalline thin layer, a substrate having a high haze factor can be produced only by a geometric influence of the discontinuous ridge parts.

In the first embodiment, the thickness of the crystalline thin layer 15 is preferably from 1 to 20 nm, more preferably from 1 to 10 nm, further preferably from 2 to 5 nm. Further, in the first embodiment, as compared with the second embodiment, higher discontinuous ridge parts can be constructed. Further, as compared with the second embodiment, a thinner crystalline thin layer 15 can be formed.

On the other hand, in the second embodiment, the thickness of the crystalline thin layer 15 is preferably from 1 to 20 nm, more preferably from 1 to 10 nm, further preferably from 2 to 5 nm.

Within the above range, an excellent transparency can be maintained, and the formation of the above-mentioned tin oxide layer having a low crystallinity can be certainly prevented.

### <TIN OXIDE LAYER>

In Figs. 1 and 2, on the crystalline thin layer 15, a first tin oxide layer 16 is formed, and on the first tin oxide layer 16, a second tin oxide layer 17 is formed.

In the present invention, on the crystalline thin layer, the tin oxide layer may be formed as one layer. However, as one of preferred embodiments, a multi-layered (in Figs. 1 and 2, two layered) tin oxide layer is formed on the silicon oxide layer, since the resistance of the tin oxide layer is maintained to be low, and the absorption of near infrared light by the tin oxide layer can be reduced.

The following description will be made with reference to e.g. a case where the first tin oxide layer 16 is a tin oxide layer not doped with fluorine, and the second tin oxide layer 17 is a tin oxide layer doped with fluorine.

Usually, if a tin oxide layer is doped with fluorine, the amount of free electrons (carrier concentration) in the layer will increase.

Here, the free electrons in the layer will lower the resistance and increase the electrical conductivity. From such a viewpoint, the larger the amount the better. However, they tend to absorb near infrared light, whereby light reaching to the semiconductor layer will be reduced. From such a viewpoint, the smaller the amount, the better.

In the transparent conductive substrate 10 for a solar cell shown in Figs. 1 and 2, while the second tin oxide layer 17 is doped with fluorine, the first tin oxide layer 16 is not doped with fluorine, whereby as compared with the conventional transparent conductive substrate for a solar cell wherein the entire tin oxide layer is doped with fluorine, the entire amount of fluorine doped can be made small, and accordingly, the entire amount of free electrons in the layer can be made small. As a result, it is possible to lower the absorption of near infrared light.

On the other hand, the electric current flows mainly through the second tin oxide layer 17 having a large amount of free electrons and a low resistance, whereby there will be little influence by the first tin oxide layer 16 having a high resistance. Namely, as the tin oxide layers as a whole, electrical conductivity of the same degree can be secured as compared with the conventional transparent conductive substrate for a solar cell wherein the entire tin oxide layer is doped with fluorine.

The tin oxide layer doped with fluorine is a layer composed mainly of SnO₂, and the proportion of SnO₂ among the components contained in the layer is preferably at least 90 mol%, more preferably at least 95 mol%.

The concentration of fluorine in the tin oxide layer doped with fluorine is preferably from 0.01 to 4 mol%, more preferably from 0.02 to 2 mol%, to SnO₂. Within such a range, the electrical conductivity will be excellent.

In the tin oxide layer doped with fluorine, the free electron density is high, as it is doped with fluorine. Specifically, the free electron density is preferably from 5×10¹⁹ to 4×10²⁰ cm⁻³, more preferably from 1×10²⁰ to 2×10²⁰ cm⁻³. Within such a range, the balance between the electrical conductivity and the absorption of near infrared light will be excellent.

The tin oxide layer not doped with fluorine may be a layer composed substantially of SnO₂ and may contain fluorine to some extent. For example, it may contain fluorine to some extent as a result of transfer and diffusion of fluorine from the tin oxide layer doped with fluorine.

In the tin oxide layer not doped with fluorine, the proportion of SnO₂ among components contained in the layer, is preferably at least 90 mol%, more preferably at least 95 mol%, further preferably at least 98 mol%. Within such a range, absorption of near infrared light can be made sufficiently low.

The tin oxide layer (as a whole in the case of the multi-layers) preferably has a sheet resistance of from 8 to 20 Ω/□, more preferably from 8 to 12 Ω/□.

The tin oxide layer (the total in the case of the multi-layers) preferably has a thickness of from 600 to 1,200 nm, more preferably from 700 to 1,000 nm. Within such a range, the haze factor for illuminant C of the transparent conductive substrate 10 for a solar cell will be particularly high, and its fluctuation will be particularly small. Further, the light transmittance, particularly the light transmittance within a wavelength region of from 400 to 1,200 nm, will be particularly high, and the electrical conductivity of the tin oxide layers will be particularly excellent. Here, in a case where the surface has irregularities as mentioned later, the thickness of the tin oxide layers is a thickness to the top of the ridge parts. Specifically, it is measured by a stylus-type thickness meter and a photograph of a cross-sectional view taken by SEM (scanning electron microscope).

The thickness of the tin oxide layer not doped with fluorine (the total thickness in a case where a plurality of such layers are present) is preferably from 10 to 600 nm, more preferably from 20 to 500 nm. Within such a range, the effect to suppress the absorption of near infrared light will be sufficiently large.

The thickness of the tin oxide layer doped with fluorine (the total thickness in a case where a plurality of such layers are present) is preferably from 100 to 700 nm, more preferably from 200 to 500 nm. Within such a range, the effects to lower the resistance will be sufficiently large.

The ratio of the thickness of the tin oxide layer not doped with fluorine (the total thickness in a case where a plurality of such layers are present) to the thickness of the tin oxide layer doped with fluorine (the total thickness in a case where a plurality of such layers are present) is preferably 3/7 to 7/3. Within such a range, the balance between the effects to suppress the absorption of near infrared light and the effects to lower the resistance will be excellent.

In Fig. 1, the first tin oxide layer 16 covers the entire surface of the discontinuous ridge parts 14 consisting of tin oxide and the crystalline thin layer 15 consisting of an oxide containing substantially no tin oxide. However, in the present invention, a part thereof may not be covered.

Similarly, in Fig. 2, the first tin oxide layer 16 covers the entire surface of the crystalline thin layer 15 consisting of an oxide containing substantially no tin oxide. However, in the present invention, a part thereof may not be covered.

Further, as shown in Figs. 1 and 2, the multi-laminated tin oxide layer preferably has irregularities over the entire surface on the side opposite to the incident light side (in Figs. 1 and 2, on the upper surface of the second tin oxide layer 17). With respect to the degree of irregularities, the height difference (height difference between ridges and dents) is preferably from 0.1 to 0.5 µm, more preferably from 0.2 to 0.4 µm. Further, the pitch between the ridges of the irregularities (the distance between the peaks of adjacent ridges) is preferably from 0.1 to 0.75 µm, more preferably from 0.2 to 0.45 µm.

When the tin oxide layer has irregularities on its surface, the haze factor of the transparent conductive substrate 10 for a solar cell will be high due to light scattering. Further, it is preferred that such irregularities are uniform over the entire surface of the tin oxide layer, since the fluctuation in the haze factor will thereby be small.

When the transparent conductive substrate for a solar cell has irregularities on the surface of the tin oxide layer, the haze factor will be large. Further, when the tin oxide layer has irregularities on its surface, light will be refracted at the interface between the tin oxide layer and a semiconductor layer. Further, when the tin oxide layer has irregularities on its surface, the interface of the semiconductor layer formed thereon with the rear electrode layer will likewise have irregularities, whereby light tends to be readily scattered.

When the haze factor becomes large, an effect such that the length (light path length) for light to travel back and forth through the semiconductor layer between the transparent conductive film (the tin oxide layer thereof) and the rear electrode layer will be long (an effect to trap light in) will be obtained, whereby the electric current value will increase.

Further, the effect to increase the haze factor can also be obtained by forming the discontinuous ridge parts 14 consisting of tin oxide and the crystalline thin layer 15 consisting of an oxide containing substantially no tin oxide in this order from the substrate 11 side between the silicon oxide layer 13 and the tin oxide layer (in Figs. 1 and 2, the first tin oxide layer 16 and the second tin oxide layer 17, the same will apply in this paragraph).

A method for forming such irregularities on the surface of the tin oxide layer is not particularly limited. The irregularities will be composed of crystallites exposed on the surface of the tin oxide layer remotest from the substrate on the side opposite to the incident light side.

Usually, in the multi-laminated tin oxide layer, it is possible to adjust the size of crystallites in the tin oxide layer remotest from the substrate by adjusting the size of crystallites in the first tin oxide layer, whereby the irregularities can be controlled to be within the above-mentioned preferred range. Also in the transparent conductive substrate 10 for a solar cell shown in Figs. 1 and 2, the first tin oxide layer 16 has irregularities on its surface, whereby the second tin oxide layer 17 has irregularities on its surface.

In order to enlarge the size of crystallites in the first tin oxide layer, a method may, for example, be mentioned wherein the concentration of fluorine is made small without doping fluorine, as mentioned above.

The thickness of the transparent conductive film formed on the substrate (in the transparent conductive substrate 10 for a solar cell shown in Figs. 1 and 2, the total of the thicknesses of the first tin oxide layer 16 and the second tin oxide layer 17) is preferably from 600 to 1,200 nm. Within such a range, the irregularities will not be too deep, whereby uniform coating with silicon will be facilitated, and the cell efficiency is likely to be excellent. Namely, the thickness of the p-layer of a photoelectric conversion layer is usually at a level of a few tens nm, and accordingly, if the irregularities are too deep, the dent portions are likely to have structural defects, or the raw material diffusion to the dent portions tends to be insufficient, whereby uniform coating tends to be difficult, and the cell efficiency is likely to deteriorate.

The transparent conductive substrate for a solar cell of the present invention is not particularly restricted with respect to the method for its production. For example, a method may preferably be mentioned wherein at least a silicon oxide layer, discontinuous ridge parts consisting of tin oxide, a crystalline thin layer consisting of an oxide containing substantially no tin oxide and a tin oxide layer are formed in this order on a substrate by means of an atmospheric pressure CVD method to obtain a transparent conductive substrate for a solar cell.

Now, the method for producing the transparent conductive substrate for a solar cell will be described with reference to a preferred embodiment employing an atmospheric pressure CVD method.

### <FORMATION OF TITANIUM OXIDE LAYER>

A substrate 11 is heated to a high temperature (e.g. 550°C) in a heating zone, while it is transported.

Then, onto the heated substrate 11, nitrogen gas and vaporized tetraisopropoxy titanium as the raw material for the titanium oxide layer 12 which is formed as the case requires, are blown. The tetraisopropoxy titanium undergoes a thermal decomposition reaction on the substrate 11, whereby a titanium oxide layer 12 is formed on the surface of the substrate 11 in a state of being transported.

### <FORMATION OF SILICON OXIDE LAYER>

Then, the substrate 11 having the titanium oxide layer 12 formed on its surface is heated again to a high temperature (e.g. 550°C), oxygen gas and silane gas as the raw material for the silicon oxide layer 13 are blown onto the titanium oxide layer 12. The silane gas and oxygen gas are mixed and reacted on the titanium oxide layer 12 of the substrate 11, whereby a silicon oxide layer 13 will be formed on the surface of the titanium oxide layer 12 of the substrate 11 in a state of being transported.

### <FORMATION OF DISCONTINUOUS RIDGE PARTS CONSISTING OF TIN OXIDE>

Then, the substrate 11 having the silicon oxide layer 13 formed on its surface, is heated again to a high temperature (e.g. 540°C), and water and tin tetrachloride as the raw material for the discontinuous ridge parts 14 are blown onto the silicon oxide layer 13. The tin tetrachloride and water are mixed and reacted on the silicon oxide layer 13 of the substrate 11, whereby discontinuous ridge parts 14 consisting of tin oxide are formed on the surface of the silicon oxide layer 13 of the substrate 11 in a state of being transported.

Further, in the present invention, as mentioned above, water and tin tetrachloride are blown under such a condition that the amount of water is at most 60 times by molar ratio to the tin tetrachloride (H₂O/SnCl₄).

Particularly, since the haze factor for illuminant C can be easily controlled within the range of from 5 to 40%, the molar ratio is preferably at most 30 times, further preferably from 2 to 30 times, particularly preferably from 5 to 20 times.

### <FORMATION OF CRYSTALLINE THIN LAYER CONSISTING OF OXIDE CONTAINING SUBSTANTIALLY NO TIN OXIDE>

Then, the substrate 11 having the discontinuous ridge parts 14 formed on its surface, is heated again to a high temperature (e.g. 540°C), and onto the surface having the discontinuous ridge parts 14, the material for the crystalline thin layer 15 consisting of an oxide containing substantially no tin oxide, for example, vaporized tetraisopropoxy titanium and nitrogen gas are blown. The tetraisopropoxy titanium undergoes a thermal decomposition reaction, whereby a crystalline thin layer (titanium oxide layer) 15 is formed on the surface of the discontinuous ridge parts 14 and the silicon oxide layer 13 of the substrate 11 in a state of being transported.

### <FORMATION OF FIRST TIN OXIDE LAYER>

Then, the substrate 11 having the crystalline thin layer 15 formed on its surface, is heated again to a high temperature (e.g. 540°C), and water and tin tetrachloride as the raw material for the first tin oxide layer 16 are blown onto the surface having the crystalline thin layer 15. The tin tetrachloride and water are mixed and reacted on the crystalline thin layer 15 of the substrate 11, whereby a first tin oxide layer 16 not doped with fluorine is formed on the surface of the crystalline thin layer 15 of the substrate 11 in a state of being transported.

### <FORMATION OF SECOND TIN OXIDE LAYER>

Then, the substrate 11 having the first tin oxide layer 16 formed on its surface is heated again to a high temperature (e.g. 540°C), and tin tetrachloride, water and hydrogen fluoride as the raw material for the second tin oxide layer 17 are blown onto the surface of the first tin oxide layer 16. The tin tetrachloride, water and hydrogen fluoride are mixed and reacted on the first tin oxide layer 16 of the substrate 11, whereby a second tin oxide layer 17 doped with fluorine is formed on the surface of the first tin oxide layer 16 of the substrate 11 in a state of being transported.

Then, while being transported, the substrate 11 having the second tin oxide layer 17 formed thereon, is passed through the annealing zone and cooled to the vicinity of room temperature, and discharged as a transparent conductive substrate for a solar cell.

The above-described method is an off line CVD method wherein formation of a transparent conductive substrate for a solar cell is carried out in a process separate from the production of a substrate. In the present invention, it is preferred to employ such an off line CVD method with a view to obtaining a high quality transparent conductive substrate for a solar cell. However, it is also possible to employ an on line CVD method wherein formation of a transparent conductive film for a solar cell is carried out, following the production of a substrate (such as a glass substrate).

The solar cell of the present invention is a solar cell employing the transparent conductive substrate for a solar cell of the present invention.

The solar cell of the present invention may be a solar cell with either one of an amorphous silicon type photoelectric conversion layer and a fine crystal silicon type photoelectric conversion layer.

Further, it may be of either a single structure or a tandem structure. Particularly preferred is a solar cell of a tandem structure.

As one of preferred embodiments of the solar cell of the present invention, a solar cell of a tandem structure may be mentioned wherein the transparent conductive substrate for a solar cell of the present invention, a first photoelectric conversion layer, a second photoelectric conversion layer and a rear electrode layer are laminated in this order.

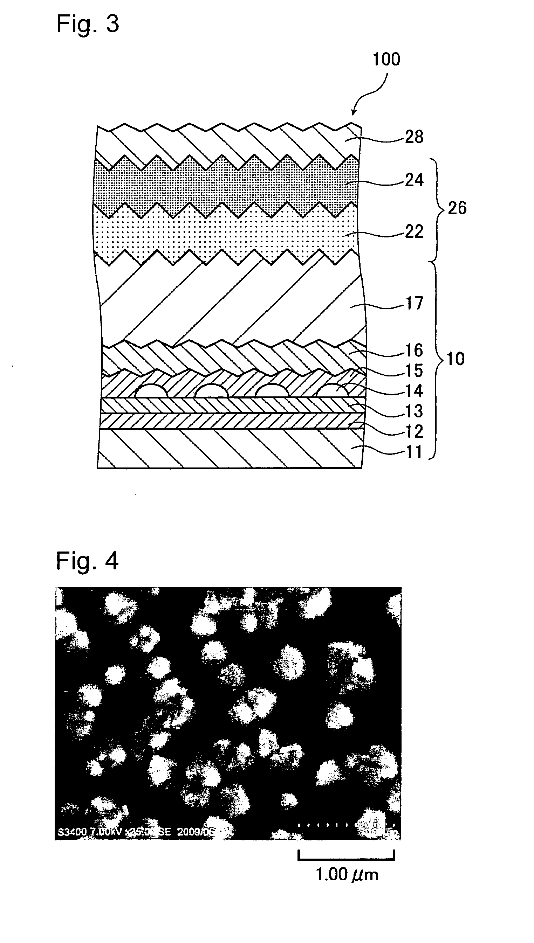

Fig. 3 is a schematic cross-sectional view illustrating an example of the solar cell of a tandem structure employing the conductive substrate for a solar cell of the present invention. In Fig. 3, the incident light side of the solar cell is located on the down side of the drawing.

The solar cell 100 shown in Fig. 3 comprises the transparent conductive substrate 10 for a solar cell of the second embodiment of the present invention, a semiconductor layer (a photoelectric conversion layer) 26 comprising a first photoelectric conversion layer 22 and a second photoelectric conversion layer 24, and a rear electrode layer 28. This is a common construction of a thin layer solar cell of a tandem structure.

Further, the solar cell 100 shown in Fig. 3 may be provided with the transparent conductive substrate for a solar cell of the first embodiment of the present invention, instead of the transparent conductive substrate 10 for a solar cell of the second preferred embodiment of the present invention.

In the solar cell 100, light enters from the side of the transparent conductive substrate 10 for the solar cell. Each of the first photoelectric conversion layer 22 and the second photoelectric conversion layer 24 has a pin structure in which a p-layer, an i-layer and an n-layer are laminated in this order from the incident light side.

Here, in the first photoelectric conversion layer 22 on the incident light side, the p-layer, the i-layer and the n-layer are made of amorphous silicon having a large band gap Eg. On the other hand, in the second photoelectric conversion layer 24 located at a further downstream side against the incident light, the p-layer, the i-layer and the n-layer are made of a crystal silicon having a small band gap Eg, such as a single crystal silicon, a poly-crystal silicon or a microcrystal silicon.

In Fig. 3, the second photoelectric conversion layer 24 is constructed by only one layer, but it may be constructed by laminating a plurality of photoelectric conversion layers which are different in the band gap Eg from one another. In a case where the second photoelectric conversion layer is constructed by laminating a plurality of photoelectric conversion layers, such layers are laminated so that the band gap Eg will be smaller towards the downstream from the incident light side.

Light entered into the solar cell 100 will be absorbed by either the first photoelectric conversion layer 22 or the second photoelectric conversion layer 24, whereby an electromotive force will be generated by a photoconduction effect. The electromotive force thus generated is taken out to the outside by means of the second tin oxide layer 17 being a transparent conductive film of the transparent conductive substrate 10 for a solar cell, and the rear electrode layer 28, as electrodes. The solar cell 100 has the first photoelectric conversion layer 22 and the second photoelectric conversion layer 24 which are different from each other in the band gap Eg, whereby the sunlight energy can be effectively utilized within a wide range of spectrum, and the photoelectric conversion efficiency will be excellent. Such effects will be further distinct by providing the second photoelectric conversion layer by laminating photoelectric conversion layers different in the band gap Eg from one another so that Eg will be smaller towards the downstream side from the incident light side.

The solar cell of the present invention may have another layer, for example, a contact-improvement layer between the rear electrode layer 28 and the second photoelectric conversion layer 24. By providing the contact-improvement layer, the contact between the rear electrode layer 28 and the second photoelectric conversion layer 24 can be improved.

The tandem type solar cell as shown in Fig. 3 is excellent in the photoelectric conversion efficiency as compared with a conventional single type amorphous silicon solar cell. In the present invention, the absorption of near infrared light by the tin oxide layer is small, and a transparent conductive substrate for a solar cell, which is excellent in the photoelectric conversion efficiency is employed, whereby the merits of the solar cell of a tandem structure will effectively be provided.

The solar cell shown in Fig. 3 can be produced by a conventional method. For example, a method may be mentioned wherein the first photoelectric conversion layer 22 and the second photoelectric conversion layer 24 are sequentially formed on the transparent conductive substrate 10 for a solar cell by means of a plasma CVD method, and further, the rear electrode layer 28 is formed by means of a sputtering method. In the case of forming a contact improvement layer, it is preferred to employ a sputtering method.

### EXAMPLES

### <PREPARATION OF TRANSPARENT CONDUCTIVE SUBSTRATE FOR SOLAR CELL>

### EXAMPLE 1

A transparent conductive substrate for a solar cell was prepared by means of an off line CVD apparatus of such a type that a plurality of gas supply devices were attached to a tunnel type heating furnace for transporting a substrate by a mesh belt. Specifically, as described below, on a glass substrate, a titanium oxide layer, a silicon oxide layer, discontinuous ridge parts consisting of tin oxide, a crystalline thin layer consisting of an oxide containing substantially no tin oxide, a first tin oxide layer not doped with fluorine, a second tin oxide layer doped with fluorine and a third tin oxide layer doped with fluorine were formed in this order to obtain a transparent conductive substrate for a solar cell.

Firstly, while the glass substrate was being transported, it was heated to 550°C in a heating zone. Here, as the glass substrate, a soda lime silicate glass substrate having a thickness of 3.9 mm and a size of 1,400 mm × 1,100 mm was used.

Then, onto the heated substrate, vaporized tetraisopropoxy titanium as the raw material for a titanium oxide layer and nitrogen gas as a carrier gas were blown by the gas supply devices to form a titanium oxide layer on the surface of the substrate in a state of being transported. Here, tetratitanium isopropoxide was put into a bubbler tank kept at a temperature of about 100°C and vaporized by bubbling with nitrogen gas and transported to the gas supply devices by a stainless steel piping.

Then, the substrate having the titanium oxide layer formed on its surface, was heated again to 550°C and then, silane gas as the raw material for a silicon oxide layer, oxygen gas and nitrogen gas as a carrier gas were blown thereon by the gas supply devices, to form a silicon oxide layer on the surface of the titanium oxide layer of the substrate in a state of being transported.

Then, the substrate having the silicon oxide layer formed on its surface, was heated again to 540°C and then, tin tetrachloride as the raw material for discontinuous ridge parts, water and nitrogen gas as a carrier gas were blown onto the surface of the silicon oxide layer by the gas supply devices, to form discontinuous ridge parts on the surface of the silicon oxide layer of the substrate in a state of being transported. Here, tin tetrachloride was put into a bubbler tank, kept at a temperature of about 55°C, vaporized by bubbling with nitrogen gas and transported to the gas supply devices by a stainless steel piping. Further, with respect to the water, steam obtained by boiling under heating was transported to the gas supply devices by another stainless steel piping.

Here, the mixing ratio of the tin tetrachloride and water was (H₂O/SnCl₄)=10 by molar ratio.

After the discontinuous ridge parts consisting of tin oxide were formed, the irregularities of the film surface were observed by SEM, and it was found that the tin oxide was not a continuous film, and formed ridge parts (island structure). Fig. 4 shows an electron microscopic photograph taken by a scanning electron microscope (SEM JSM-820, manufactured by JEOL Ltd.), which shows the surface after discontinuous ridge parts consisting of tin oxide were formed.

Here, the bottom diameters of 10 ridge parts randomly selected from ridge parts in 4 µm² of an SEM image (35,000 times power) of a substrate observed from directly above, were measured, the SEM image was processed, and the average bottom diameter was calculated. As a result, the average bottom diameter was 308 nm, the average density was 6.3 ridges/µm², and the average covering proportion on the surface of the silicon oxide layer was 47%.

Then, the substrate having the discontinuous ridge parts consisting of tin oxide formed on its surface, was heated again to 550°C, and then vaporized tetraisopropoxy titanium as the raw material for a crystalline thin layer consisting of titanium oxide and nitrogen gas as a carrier gas were blown onto the surface of the ridge parts by the gas supply devices to form a crystalline thin layer (titanium oxide layer) on the surface of the discontinuous ridge parts consisting of tin oxide and the silicon oxide layer, of the substrate in a state of being transported. Here, tetratitanium isopropoxide was put into a bubbler tank kept at a temperature of about 100°C and vaporized by bubbling with nitrogen gas and transported to the gas supply devices by a stainless steel piping.

Then, the substrate having the crystalline thin layer formed on its surface, was heated again to 540°C and then, tin tetrachloride as the raw material for a first tin oxide layer, water and nitrogen gas as a carrier gas were blown onto the surface of the crystalline thin layer by the gas supply devices, to form a first tin oxide layer not doped with fluorine on the surface of the crystalline thin layer of the substrate in a state of being transported. Here, tin tetrachloride was put into a bubbler tank, kept at a temperature of about 55°C, vaporized by bubbling with nitrogen gas and transported to the gas supply devices by a stainless steel piping. Further, with respect to the water, steam obtained by boiling under heating was transported to the gas supply devices by another stainless steel piping.

Then, the substrate having the first tin oxide layer formed on its surface was heated again to 540°C, and then, by the gas supply devices, tin tetrachloride as the raw material for a second tin oxide layer, water and nitrogen gas as a carrier gas were blown thereonto to form a second tin oxide layer doped with fluorine, on the surface of the first tin oxide layer of the substrate in a state of being transported. Here, tin tetrachloride and water were transported to the gas supply devices in the same manner as in the case for the first tin oxide layer. Further, with respect to the hydrogen fluoride, vaporized hydrogen fluoride was transported to the gas supply devices by a stainless steel piping and supplied in a state as mixed with tin tetrachloride onto the first tin oxide layer.

Then, the substrate having the second tin oxide layer formed on its surface was heated again to 540°C, and then, by the gas supply devices, tin tetrachloride as the raw material for a third tin oxide layer, water, hydrogen fluoride and nitrogen gas as a carrier gas were blown thereonto to form a third tin oxide layer doped with fluorine, on the second tin oxide layer of the substrate in a state of being transported. Here, tin tetrachloride, water and hydrogen fluoride were transported to the gas supply devices in the same manner as the case for the second tin oxide layer.

The formed third tin oxide layer had fine irregularities (texture) uniformly on the film surface.

The mixing ratio of water to tin chloride in the first tin oxide layer, the second tin oxide layer and the third tin oxide layer was adjusted to H₂O/SnCl₄=80 by molar ratio in all layers. Further, the thickness of the first tin oxide layer, the second tin oxide layer and the third tin oxide layer was adjusted to be 270 nm in all layers, and the total thickness was 810 nm.

Further, the amount of hydrogen fluoride added to each of the second tin oxide layer and the third tin oxide layer was HF/SnCl₄=0.4 by molar ratio.

While being transported, the substrate having the third tin oxide layer formed, was passed through an annealing zone and cooled to near room temperature, to obtain a transparent conductive substrate for a solar cell.

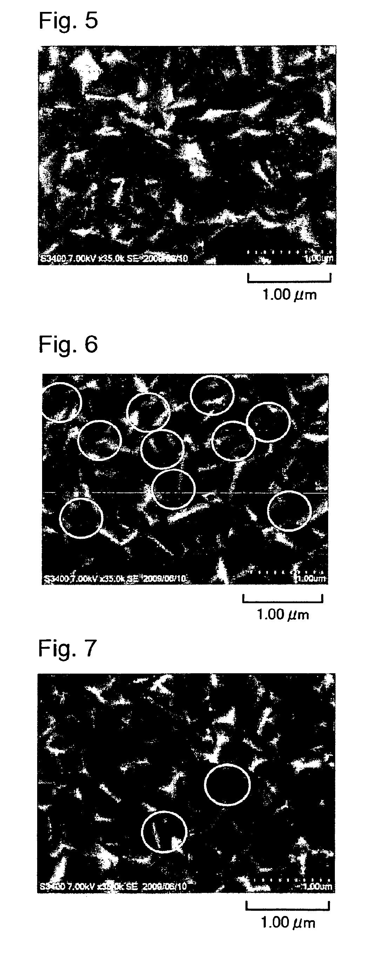

Fig. 5 shows an electron microscopic photograph (35,000 times power) taken by a scanning electron microscope (SEM JSM-820, manufactured by JEOL Ltd.), which shows the surface of the transparent conductive substrate for a solar cell prepared in Example 1.

### COMPARATIVE EXAMPLE 1

A transparent conductive substrate for a solar cell was obtained in the same manner as in Example 1 except that discontinuous ridge parts consisting of tin oxide and a crystalline thin layer consisting of titanium oxide were not formed.

Fig. 6 shows an electron microscopic photograph (35,000 times power) taken by a scanning electron microscope (SEM JSM-820, manufactured by JEOL Ltd.), which shows the surface of the transparent conductive substrate for a solar cell prepared in Comparative Example 1.

### COMPARATIVE EXAMPLE 2

A transparent conductive substrate for a solar cell was obtained in the same manner as in Example 1 except that instead of the crystalline thin layer consisting of titanium oxide, a non-crystalline thin layer consisting of silicon oxide was formed.

Fig. 7 shows an electron microscopic photograph (35,000 times power) taken by a scanning electron microscope (SEM JSM-820, manufactured by JEOL Ltd.), which shows the surface of the transparent conductive substrate for a solar cell prepared in Comparative Example 2.

Further, the non-crystalline thin layer consisting of silicon oxide was formed under the same condition as in the formation of the silicon oxide layer formed on the titanium oxide layer.

### <EVALUATION OF PHYSICAL PROPERTIES>

With respect to the glass substrates provided with a transparent conductive film for a solar cell thus obtained, physical properties were evaluated as described below. Results are shown in Table 1.

### (1) AVERAGE TRANSMITTANCE

Spectral transmittance within the wavelength region of from 400 nm to 1,200 nm, was measured by a spectrophotometer (U-341 0 self-recording spectrophotometer, manufactured by Hitachi, Ltd.) employing an integrating sphere.

In the measurement, apparent decrease of transmittance due to transmitting components while scattering (haze) was corrected. This correction was carried by a known method (a surface having irregularities of a transparent conductive film was made to be in contact with a quartz glass substrate, and methane diionide (CH₂l₂) was sandwiched between them) (described in e.g. Jpn. J. Appl. Phys. 27 (1988) 2,053, or Asahi Glass Res. Rep. 127 (1987) 13).

Based on the measured value of the spectral transmittance, an average value of transmittance (average transmittance) at a short wavelength side (from 400 to 550 nm) was calculated.

Here, absorptance is a value subtracting transmittance and reflectance from 100% (100 - (transmittance% + reflectance%)). However, in the present examples, since the reflectance is almost constant, an effect of low absorptance is expressed as increase of transmittance.

### (2) HAZE FACTOR FOR ILLUMINANT C

With respect to a sample for measurement cut out from a glass substrate provided with a transparent conductive film for a solar cell, the haze factor for illuminant C was measured by means of a haze meter (HZ-1 model, manufactured by Suga Test Instruments Co., Ltd.).

Here, the haze factor of the entire surface of the substrate is visually substantially uniform. Therefore, a typical portion of the substrate was selected and cut out to obtain a sample for measurement.

**TABLE 1**

| | Discontinuous ridge parts | | | | Crystalline/non-crystalline thin layer | | Total thickness of tin oxide layer (nm) | Average transmittance (%) | Haze factor for illuminant C (%) |
|---|---|---|---|---|---|---|---|---|---|
| | Average bottom diameter (nm) | Average density (ridges/µm²) | Average covering proportion (%) | Average H₂O/SnCl₄ molar ratio | Types | Thickness (nm) | | | |
| Ex. 1 | 308 | 6.3 | 47 | 10 | TiO₂ (crystalline) | 5 | 810 | 88.9 | 20 |
| Comp. Ex. 1 | - | - | - | - | - | - | 810 | 86.7 | 30 |
| Comp. Ex. 2 | 308 | 6.3 | 47 | 10 | SiO₂(non-crystalline) | 5 | 810 | 88.1 | 30 |

It is evident from Table 1 that as compared with Comparative Example 1 wherein the transparent conductive substrate for a solar cell was produced without forming anything between the silicon oxide layer and the tin oxide layer (first tin oxide layer), in the case of the transparent conductive substrate for a solar cell of Example 1, which had the discontinuous ridge parts consisting of tin oxide and the crystalline thin layer consisting of an oxide substantially containing no tin oxide, the transmittance at a wavelength region of from about 400 to 500 nm increased.

Similarly, it is evident that as compared with the transparent conductive substrate for a solar cell of Comparative Example 2, which had the non-crystalline thin layer consisting of silicon oxide, in the case of the transparent conductive substrate for a solar cell of Example 1, the transmittance in a wavelength region of from about 400 to 500 nm increased.

Further, it is evident from electron microscope photographs of Figs. 5 to 7 that on all surfaces of the transparent conductive substrates for a solar cell prepared in Example 1 and Comparative Examples 1 and 2, crystal particles having a crystalline polyhedral shape were formed.

Here, it is evident by comparing parts where the crystal particles are in contact with one another, namely grain boundary that in Example 1 (Fig. 5), a structure such that the grain boundary parts were filled with small crystal particles is observed, while in Comparative Example 1 (Fig. 6), many grooved structures (in Fig. 6, parts circled by a white circle) are observed such that the grain boundary cuts into the film thickness direction, and in Comparative Example 2 (Fig. 7), although the grain boundary parts are filled with small crystal particles, such crystal particles are not in contact with one another, and holes (in Fig. 7, parts circled by a white circle) are formed.

Accordingly, in the case of the transparent conductive substrates for a solar cell prepared in Comparative Examples 1 and 2, the covering film thickness of an power generation layer formed on the substrate tends to be ununiform, and taking the Non-Patent Document (M. Python et al. Journal of non-crystalline solids 354 (2008) 2,258-2,262) into consideration, Voc (open circuit voltage) and FF (fill factor) which represent battery properties tend to deteriorate.

### <PREPARATION OF TRANSPARENT CONDUCTIVE SUBSTRATE FOR SOLAR CELL>

### EXAMPLES 2 to 4

Transparent conductive substrates for a solar cell were produced in the same manner as in Example 1 except that without changing the H₂O/SnCl₄ molar ratio, the total amount of tin tetrachloride and water was changed to change the height of the discontinuous ridge parts as values shown in the following Table 2.

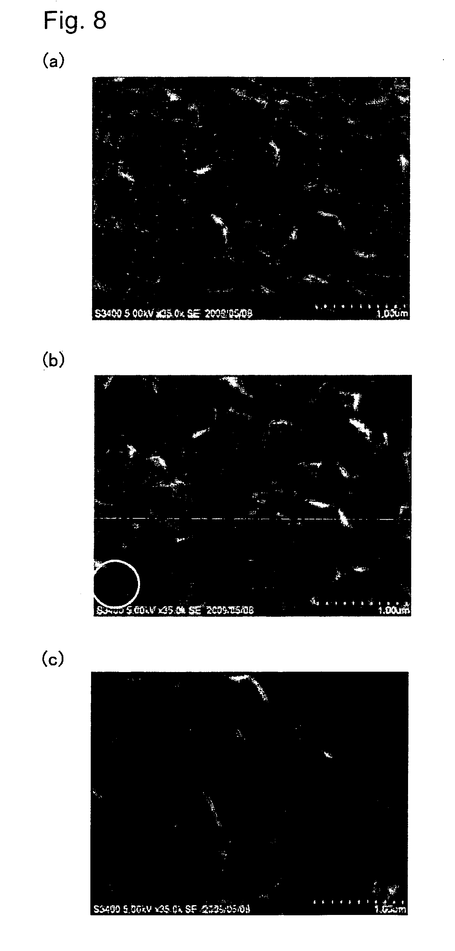

Figs. 8(a) to (c) show electron microscopic photographs (35,000 times power) taken by a scanning electron microscope (SEM JSM-820, manufactured by JEOL Ltd.), which show the surfaces of the transparent conductive substrates for a solar cell prepared in Examples 2 to 4.

### COMPARATIVE EXAMPLES 3 to 5

Transparent conductive substrates for a solar cell were produced in the same manner as in Examples 2 to 4 except that a crystalline thin layer consisting of titanium oxide was not formed.

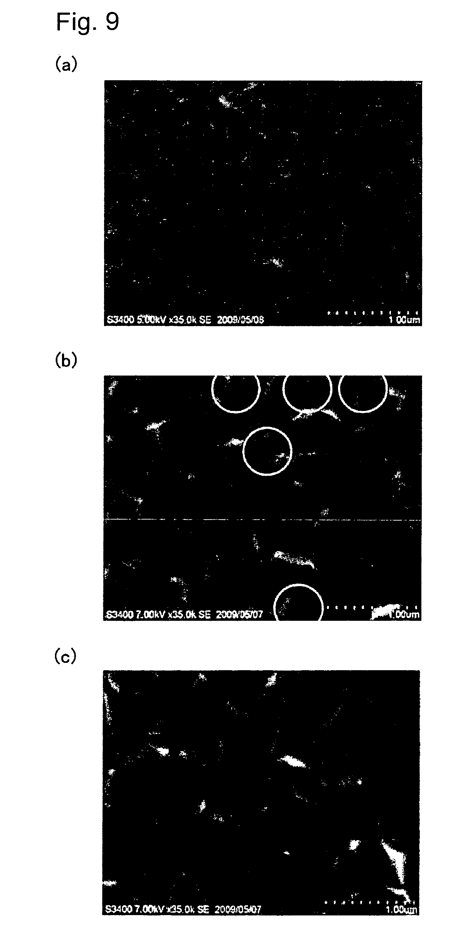

Figs. 9(a) to (c) show electron microscopic photographs (35,000 times power) taken by a scanning electron microscope (SEM JSM-820, manufactured by JEOL Ltd.), which show the surfaces of the transparent conductive substrates for a solar cell prepared in Comparative Examples 3 to 5.

### <EVALUATION OF PHYSICAL PROPERTIES>

The haze factor for illuminant C of the glass substrates provided with the transparent conductive film for a solar cell prepared in Examples 2 to 4 and Comparative Examples 3 to 5 was measured in the same manner as in Example 1. Results are shown in the following Table 2.

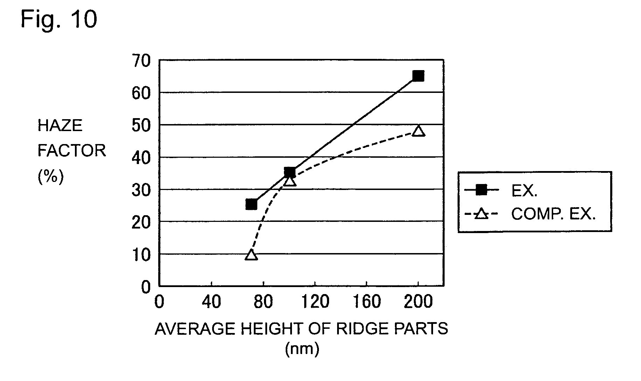

Further, Fig. 10 shows the relationship of an average height of the discontinuous ridge parts and the haze factor (control of the haze factor) in the transparent conductive substrates for a solar cell prepared in Examples 2 to 4 and Comparative Examples 3 to 5.

**TABLE 2**

| | Average height of discontinuous ridge parts (nm) | Presence of a crystalline thin layer | Haze factor for illuminant C (%) |
|---|---|---|---|
| Ex. 2 | 70 | Present | 25 |
| Ex. 3 | 100 | Present | 35 |
| Ex. 4 | 200 | Present | 65 |
| Comp. Ex. 3 | 70 | Nil | 10 |
| Comp. Ex. 4 | 100 | Nil | 33 |
| Comp. Ex. 5 | 200 | Nil | 48 |

It is evident from Table 2 and Fig. 10 that as compared with Comparative Examples 3 to 5 wherein discontinuous ridge parts were formed under the same condition, and a crystalline thin layer was not formed, the haze factor for illuminant C tended to increase in Examples 2 to 4. That is, the haze was easily controlled in Examples 2 to 4.

Further, as shown in Figs. 8 and 9, even though the transparent conductive substrates for a solar cell have a similar haze factor for illuminant C, if the number of defects of the tin oxide layer (in Figs. 8 and 9, parts circled by a white circle) is compared, Fig. 8(b) (Example 3) has one defect, while Fig. 9(b) (Comparative Example 4) has five defects. Thus, as compared with the transparent conductive substrate for a solar cell prepared in Comparative Example 4, in the case of the transparent conductive substrate for a solar cell prepared in Example 3, the covering film thickness of a power generation layer on the substrate tends to be uniform, and taking the Non-Patent Document (M. Python et al. Journal of non-crystalline solids 354 (2008) 2,258-2,262) into the consideration, Voc (open circuit voltage) and FF (fill factor) which represent battery properties are improved.

It is evident from the above results that by forming discontinuous ridge parts and a crystalline thin layer, the improvement of the haze factor for illuminant C and the improvement of battery properties which are in the relationship of tradeoff in conventional transparent conductive substrates for a solar cell, can be both established.

### INDUSTRIAL APPLICABILITY

According to the present invention, a transparent conductive substrate for a solar cell can be obtained which has a high haze factor at the same level as a conventional transparent conductive substrate for a solar cell and a small absorption of light in a wavelength region of about 400 nm in a tin oxide layer. The transparent conductive substrate for a solar cell of the present invention is useful for a solar cell.

The entire disclosures of Japanese Patent Application No. 2009-177702 filed on July 30, 2009 and Japanese Patent Application No. 2010-154101 filed on July 6, 2010 including specifications, claims, drawings and summaries are incorporated herein by reference in their entireties.

### REFERENCE SYMBOLS

- 10:: Transparent conductive substrate for a solar cell
- 11:: Substrate
- 12:: Titanium oxide layer
- 13:: Silicon oxide layer
- 14:: Discontinuous ridge parts consisting of tin oxide
- 15:: Crystalline thin layer consisting of an oxide containing substantially no tin oxide
- 16:: First tin oxide layer
- 17:: Second tin oxide layer
- 22:: First photoelectric conversion layer
- 24:: Second photoelectric conversion layer
- 26:: Semiconductor layer (photoelectric conversion layer)
- 28:: Rear electrode layer
- 100:: Solar cell

## Claims

1. A transparent conductive substrate for a solar cell, comprising a substrate and at least a silicon oxide layer and a tin oxide layer formed thereon in this order, wherein on the silicon oxide layer between the silicon oxide layer and the tin oxide layer, discontinuous ridge parts consisting of tin oxide and a crystalline thin layer consisting of an oxide containing substantially no tin oxide are formed.

2. The transparent conductive substrate for a solar cell according to Claim 1, wherein the ridge parts and the crystalline thin layer are formed so as to contact the tin oxide layer.

3. The transparent conductive substrate for a solar cell according to Claim 1, wherein the ridge parts are covered with the crystalline thin layer.

4. The transparent conductive substrate for a solar cell according to any one of Claims 1 to 3, wherein the ridge parts have an average bottom surface diameter of from 20 to 1,000 nm, an average density of from 1 to 100 ridges/µm² and an average covering proportion of from 3 to 90% on the surface of the silicon oxide layer.

5. The transparent conductive substrate for a solar cell according to any one of Claims 1 to 4, wherein the ridge parts have an average height of from 10 to 200 nm, an average bottom surface diameter of from 20 to 1,000 nm, an average density of from 1 to 100 ridges/µm² and an average covering proportion of from 3 to 90% on the surface of the silicon oxide layer.

6. The transparent conductive substrate for a solar cell according to any one of Claims 1 to 5, wherein the ridge parts are formed by atmospheric pressure CVD method using tin tetrachloride and water wherein the amount of water is at most 60 times by molar ratio to the tin tetrachloride (H₂O/SnCl₄).

7. The transparent conductive substrate for a solar cell according to any one of Claims 1 to 6, wherein the haze factor for illuminant C is from 5 to 40%.

8. The transparent conductive substrate for a solar cell according to Claim 7, wherein the ridge parts are formed by atmospheric pressure CVD method using tin tetrachloride and water wherein the amount of water is at most 30 times by molar ratio to the tin tetrachloride (H₂O/SnCl₄).

9. The transparent conductive substrate for a solar cell according to any one of Claims 1 to 8, wherein the crystalline thin layer is a titanium oxide layer.

10. The transparent conductive substrate for a solar cell according to any one of Claims 1 to 8, which further has a titanium oxide layer between the substrate and the silicon oxide layer.

11. A solar cell, which has the transparent conductive substrate for a solar cell as defined in any one of Claims 1 to 10.

12. A process for producing the transparent conductive substrate for a solar cell, which comprises forming by atmospheric pressure CVD method, at least a silicon oxide layer, discontinuous ridge parts consisting of tin oxide, a crystalline thin film consisting of an oxide containing substantially no tin oxide and a tin oxide layer in this order on a substrate, wherein the ridge parts are formed by atmospheric pressure CVD method using tin tetrachloride and water wherein the amount of water is at most 60 times by molar ratio to the tin tetrachloride (H₂O/SnCl₄).
